# EUROPEAN PATENT APPLICATION

(11) **EP 1 199 909 A1**
(43) Date of publication of application: **24.04.2002**
(21) Application number: 01912253.0
(22) Date of filing: 12.03.2001
(51) Int. Cl.: H05B 33/10, H05B 33/14

(54) **METHOD AND APPARATUS FOR MANUFACTURING ORGANIC EL DISPLAY**

(30) Priority: 22.03.2000 JP 2000080798
(71) Applicant: IDEMITSU KOSAN CO., LTD., Tokyo 100-8321 (JP)
(72) Inventor: SAKAI, Toshio, Sodegaura-shi, Chiba 299-0293 (JP); EIDA, Mitsuru, Sodegaura-shi, Chiba 299-0293 (JP); TOKAILIN, Hiroshi, Sodegaura-shi, Chiba 299-0293 (JP)
(74) Representative: Gille Hrabal Struck Neidlein Prop Roos
(86) International application number: PCT/JP01/01893
(87) International publication number: WO 01/72091

(57) **Abstract**

A wastewater treatment apparatus for aerobic treatment of an organic waste water by means of microbes carried on a carrier, wherein (503) are heaped up which have a container (504) filled with carriers (505, 506) having microbes carried thereon, the tank has an area S' of the side for discharging the wastewater being smaller than an area S of that for receiving the wastewater, and the plurality of tanks heaped up are arranged in a manner such that even when carriers are retrenched sludge does not accumulate in a tank and can be sent into the tank directly below it. An organic waste water is introduced into a plurality of tanks arranged to form multiple stages, is subjected to an aerobic treatment, and then is discharged. The apparatus allows the aerobic treatment of an organic waste water by means of microbes to be kept satisfactory even when meshed are clogged by sludge or carriers are retrenched due to the use for a long period of time.

## Description

### BACKGROUND OF THE INVENTION

### Field of the Invention

The present invention relates to a waste water treating device for aerobically decomposing organic matters contained in waste water through the action of microorganisms held on carriers, and to a method of recycling a waste water treatment material.

### Description of Related Art

Methods of treating organic waste water using aerobic microorganisms have been studied and developed. For example, an activated sludge method is usually used in sewage treatment plants, and a submerged infiltration bed method is used along with the activated sludge method in combined waste water purifying tanks.

In addition, methods in which domestic kitchen garbage or the like is fragmented or liquefied by a disposal unit so that it can be treated as waste water containing garbage have also been developed. For example, Japanese Patent Laid-Open Publication No. Hei 9-1117 discloses an apparatus in which waste water containing garbage is introduced into a solid substance treating section which decomposes a solid substance by means of microorganisms and discharges primary treated water, which is then introduced into a waste water treating tank for aeration. In this manner, solid substances are decomposed and removed from the waste water containing garbage from the garbage disposal, and the waste water is purified.

In the apparatus disclosed in the above publication, waste water is subjected to aeration by an air diffuser in the waste water treating tank, which is a treatment basically similar to the activated sludge method. The present inventors, on the other hand, found that purification of waste water can be performed more effectively when a waste water treating device (a secondary treating device) comprising a packed layer packed with microorganism carriers is provided downstream of the solid substance treating device (a primary treating device). (See Japanese Patent Laid-Open Publication No. Hei 11-19674.)

Because such a waste water treating device comprises a mesh basket packed with microorganism carriers, problems such as the following are created. Namely, the mesh basket is clogged with sludge or the like after a long term use and the waste water introduced into the mesh basket would overflow along the outer sides of the basket. As a result, an aerobic treatment would be inoperative or the treating efficiency would be decreased. Further, when a plurality of mesh baskets containing microorganism carriers stacked in multi-levels are employed, the microorganism carriers would shrink as a whole after a long term use, and a gap would be created between the baskets. If, because of such a gap, the layers of microorganism carriers along which the organic waste water flows become discontinuous, the waste water cannot slow smoothly. As a result, sludge contained in the organic waste water can accumulate in the gap, such that the aerobic treatment becomes impossible or such that treatment efficiency is greatly reduced.

The present invention was made so as to overcome the above problems of the related art, and aims to provide a waste water treating device comprising a mesh basket packed with microorganism carriers, which is capable of aerobic treatment of waster water even when the waste water overflows along the sides of the mesh basket clogged with accumulated sludge or the like. Also, the waste water treating device of the present invention can prevent creation of gap between the mesh baskets, secure smooth flow of the organic waste water, and prevent reduction in the efficiency for aerobic treatment, even when the microorganism carriers shrink.

In a waste treatment apparatus or the like, solid substances having been separated from waste water containing garbage are aerobically decomposed using microorganisms in a composting device thereby obtaining compost. On the other hand, organic matter in liquid, namely organic waste water, is also aerobically decomposed using microorganisms in a waste water treatment device. Here, it is necessary to change the microorganism carriers used in the waste water treating device about every six months, because these carriers become clogged after long term use, and a large amount of the carriers, such as wood chips, are discharged at the time of exchange.
However, such wood chips cannot be used as compost because wood fibers remain therein, and must therefore be treated as waste.

On the other hand, in the compost device, the microorganism carriers are aerobically treated and discharged as compost. Therefore, a large amount of new microorganisms carriers must be supplied. In this case, after new wood chips are supplied, a certain time is required for the microorganisms to sufficiently grow.

### SUMMARY OF THE INVENTION

The present invention aims to simultaneously achieve effective treatment of microorganism carriers which have been used in a waste water treating device and reduction in the time required for preparing microorganisms when the microorganism carriers are supplied to a composting device.

A waste water treating device according to the present invention comprises a plurality of columns stacked in multi-levels, which are packed with microorganism carriers, wherein organic waste water is aerobically treated in the columns and is then discharged from the waste water treating device, and, in said columns, the area of a surface at the waste water discharging side is smaller than the area of a surface at the waste water introducing side. With such a configuration, even when the waste water overflows the column clogged with accumulation of sludge or the like and flows down along the sides of the column, the overflowing waste water can still be treated aerobically. Further, even when the microorganism carriers shrink, no gap is created between the columns, and no sludge accumulates in the columns. Therefore, smooth flow of the organic waste water can be ensured, and reduction in the efficiency for aerobic treatment can be prevented.

Further, according to the present invention, a large amount of wood chips which have been used in the waste water treating device discharged at the time of changing the microorganism carriers can be recycled as microorganism carriers for use in the composting device so that they can finally be used as compost. In addition, because the microorganisms have sufficiently grown in these used wood chips, the time required for preparing the microorganisms can be shortened when the wood chips are supplied in exchange of the used microorganism carriers, and thus efficient treatment is possible.

By applying the waste water treating device and the method of recycling the waste water treatment material according to the present invention to a garbage treatment apparatus, for example, organic waste water such as liquid from a disposal unit or kitchen waste water can be effectively treated due to a preferable aerobic treatment.

### BRIEF DESCRIPTION OF THE DRAWINGS

These and other objects of the invention will be explained in the description below, in connection with the accompanying drawings, in which:
FIG. 1 is a view showing the overall structure of an example waste treatment apparatus to which a waste water treating device and a method of recycling a waste water treatment material according to the present invention are applied;
FIG. 2 is a partial perspective view of a solid-liquid separating device of Fig. 1;
FIG. 3(a) is a perspective view of a column packed with microorganism carriers, and FIG. 3(b) is a view for explaining the effect of the column of the present invention in comparison with the conventional column;
FIG. 4 is a graph showing experimental results of Example 1; and
FIG. 5 is a graph showing experimental results of Example 1.

### DETAILED DESCRIPTION OF THE PREFERRED EMBODIMENT

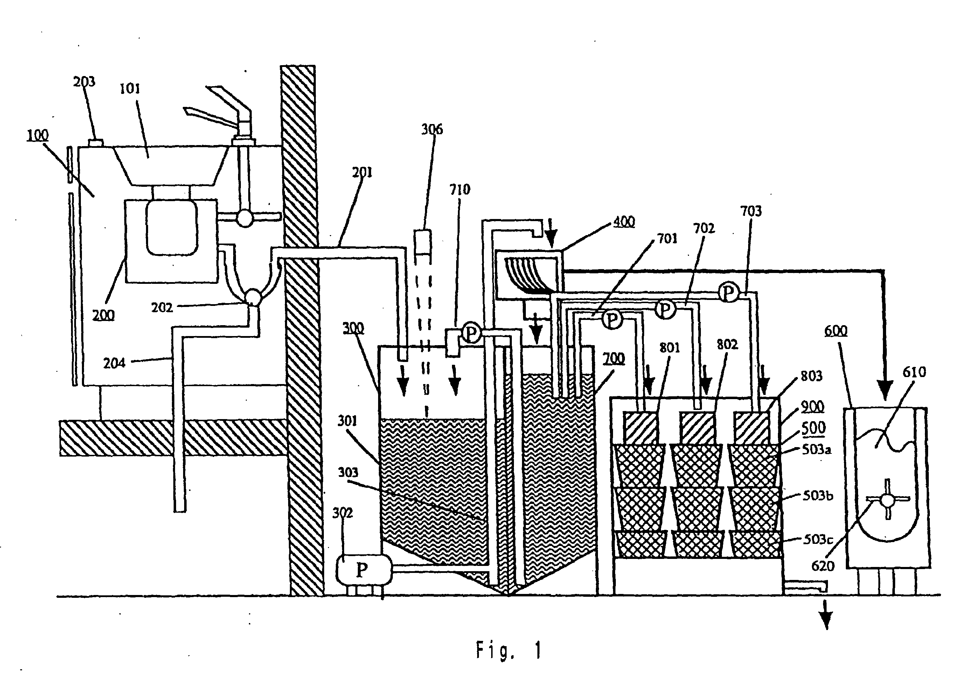

A first embodiment of the waste water treating device and the recycling method of the waste water treatment material according to the present invention will be described with reference to the accompanying drawings. First, with reference to Fig. 1, a waste treatment apparatus will be described as one example of an apparatus for treating water containing garbage, waste water, foul water, or the like, to which the waste water treating device and the recycling method of waste water treatment material according to the present invention are applied.

The waste treatment apparatus comprises a disposal 200 for finely grinding, mulching, or similarly reducing into a fine composition waste discharged from a sink 101 of the kitchen counter 100; a flow rate controlling tank 300 into which flows a mixture from the disposal of a solid substance such as ground garbage or the like and a liquid substance such as kitchen waste water or the like; a solid-liquid separating device 400 for separating the mixture into a solid substance and a liquid substance; a precipitation-separation tank 700 for precipitating fine particles in the liquid component; supply pipes 701 ∼ 703 for distributing a supernatant pumped from the precipitation-separation tank 700 into waste water treating device 500 of the present invention via sludge treatment devices 801 ∼ 803 which reduce floating matters in the supernatant; the waste water treating device 500 for performing a purification treatment of the supernatant; and a composting device (solid substance treating device) 600 for composting the solid substance.

The disposal 200, which includes an electromagnetic valve 202 and a start switch 203, is disposed under the sink 101 while the solid-liquid separating device 400, the precipitation tank 700, the sludge treating devices 801 ∼ 803, the waste water treating device 500, and the composting device 600 are housed in a body case (not shown) and located outside the house. The mixture discharged from the disposal 200 is temporarily introduced into the flow rate controlling tank 300 through an introduction pipe 201.

When only water, which is harmless to the environment when discharged into sewerage, is to be directly discharged through the discharge pipe 204, the start switch is turned OFF to inhibit start of the disposal 200. The electromagnetic valve 202 then causes the disposal 200 and the discharge pipe 204 to communicate each other, so that water from the sink 101 is discharged into sewerage.

On the other hand, when garbage or waste is to be discharged along with water from the sink 101, it is not desirable to discharge untreated water containing waste, and therefore the start switch 203 is turned ON to start the disposal 200. The electromagnetic valve 202 then causes the disposal 200 and the introduction pipe 201 to communicate with each other, so that composting and purification of waste water, as will be described later, is performed.

The flow rate controlling tank 300 comprises a storage tank 301 for storing the mixture introduced through the introduction pipe 201, a solid substance transporting air lift pump 302 for transporting the mixture mainly composed of solid substances existing at the base portion of the storage tank 301 to the solid-liquid separating device 400 through the pipe 303, and a water level sensor 306 for detecting the water level of the mixture stored in the storage tank 301.

The air lift pump 302 supplies compressed air from an air compressor into the lower part of an air lift pipe located within the storage tank 301 so as to introduce air into the air lift pipe, thereby transporting the waste water containing solid substances stored in the storage tank 301.

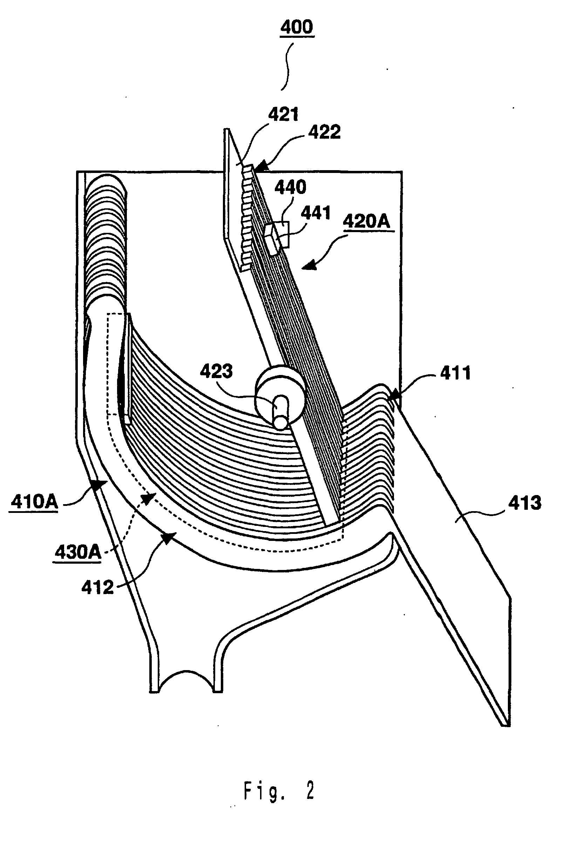

The solid-liquid separating device 400 may have a structure as disclosed in Japanese Patent Laid-Open Publication No. 2000-15010. More specifically, as shown in Fig. 2, the solid-liquid separating device 400 comprises a first slit portion 410A having a great large number of drain slots 411 formed therein, a transport portion 420A which rotates for transporting the mixture having been subjected to solid-liquid separation, a second slit portion 430A which is inserted between the great number of drain slots 411 and swings between the drain slots for accelerating solid-liquid separation of the introduced mixture, and a position detection portion 440 for detecting the position of the transport portion 420A. The first slit portion 410A, the transport portion 420A, and the second slit portion 430A are integrally resin molded by from resin, plastic, or the like.

The first slit portion 410A has arc-shaped semicircular drain teeth 412 for screening and draining the mixture introduced through the introduction pipe 201, and an introduction plate 413 for guiding the mixture having been subjected to draining (solid substances in this example) to the solid substance treating device 600. Each of the drain slots 411 is formed between drain teeth 412.

The transport portion 420A is fixed to a rotation shaft 423 coupled to a motor (not shown), and is composed of a transport plate 421 for transporting solid substances and ribs 422 provided on the rear surface of the transport plate 421.

The ribs 422 are provided so as to provide the transport plate 421, which is formed of a thin plastic material, with sufficient strength to resist deformation.

The introduced mixture is subjected to solid-liquid separation at the first slit portion 410A, such that the solid substances are separated from liquid and are accumulated on the first slit portion 410A. On the other hand, the second slit portion 430A connected to the lower end portion of the transport portion 420A is rotated back and forth a plurality of times, to thereby accelerate the solid-liquid separation by the first slit portion 410A. Then, with one clockwise rotation of the transport portion 420A, the solid substances are transported onto the transport plate 421, which then drops them onto the introduction plate 413.

Numeral 700 denotes the precipitation-separation tank 700 which precipitates fine particulate from the liquid component supplied from the solid-liquid separating device 400, and numeral 500 denotes the waste water treating device according to the present invention, which treats organic waste water whose floating matters have been reduced in the sludge treating devices 801 ∼ 803.

The composting device 600 comprises a treating tank 610 for storing the solid substances introduced after solid-liquid separation, a stirrer 620 for stirring the solid substances, and a heater or the like (not shown). The solid substances and the carriers are mixed by the stirrer 620 while air is introduced inside the treating tank 610 which is maintained at a predetermined temperature (30°C ∼ 40°C in the present embodiment) by the heater, to thereby accelerate activation of the microorganisms or the like.

The operation of the waste treatment apparatus having the above structure will next be described. When waste is to be treated, the start switch 203 is turned ON to start the disposal 200. As a result, the electromagnetic valve 202 is operated so that garbage discharged from the sink 101 is ground in the disposal 200 and is then introduced into the storage tank 301 through the introduction pipe 201.

When waste treatment is not required (for example, when fresh water is discharged), the start switch 200 is left OFF. In this state, the electromagnetic valve 202 would not operate, so that waste water or the like flows directly into the discharge pipe 204.

Most of the solid substances contained in the mixture introduced into the storage tank 301 precipitate and collect at the bottom of the storage tank 301, and are transported through the pipe 303 to the solid-liquid separation device 400 by means of the solid substance transporting air lift pump 302. At this point, the state of the transport portion 420A of the solid-liquid separating device 400 is as shown in Fig. 2. Specifically, the transport plate 421 awaits introduction of the mixture at a standby position.

Accordingly, the mixture transported from the flow rate controlling tank 300 contacts the transport plate 421 and loses energy and speed, such that it accumulates on the first slit portion 410A. The transport portion 420A and the second slit portion 430A swing back and forth by means a motor (not shown). This swinging movement causes the agglomeration of the mixture containing the separated solid substances to be stirred for draining, so that solid-liquid separation can be performed with high efficiency. Because the optimum number of swing depends on the type of solid substance, the number of swinging movements for each introduction of the mixture can preferably be set to a rate optimized for the introduced substance. However, from the standpoint of solid-liquid separation efficiency, a range of 5 ∼ 40 times is preferable.

After a predetermined number of swinging movements, the transport portion 420A makes substantially one revolution clockwise, so that the solid substances separated from the liquid component is placed into the composting device 600 via the introduction plate 413.

The treating tank 610 of the composting device 600 contains the carriers composed of wood chips or shavings and activated carbon for cultivating microorganisms. The solid substances having been subjected to solid-liquid separation and introduced into the treating tank are decomposed for composting, and then prepared for discharge by bagging or the like.

A waste treatment apparatus, which is one example to which the waste water treating device and the waste water treatment material according to the present invention can be applied, has the above-described structure. Examples of the waste water treating device and the method of recycling the waste water treatment material according to the present invention will now be described.

### (Example 1)

Example 1, which is an example of the waste water treating device according to the present invention, will be described with reference to Figs. 1, and 3 to 5. The waste water treating device 500 comprises microorganism carriers, and aerobically treats organic waste water using microorganisms held on the carriers. More specific structure of the waste water treating device 500 will be described.

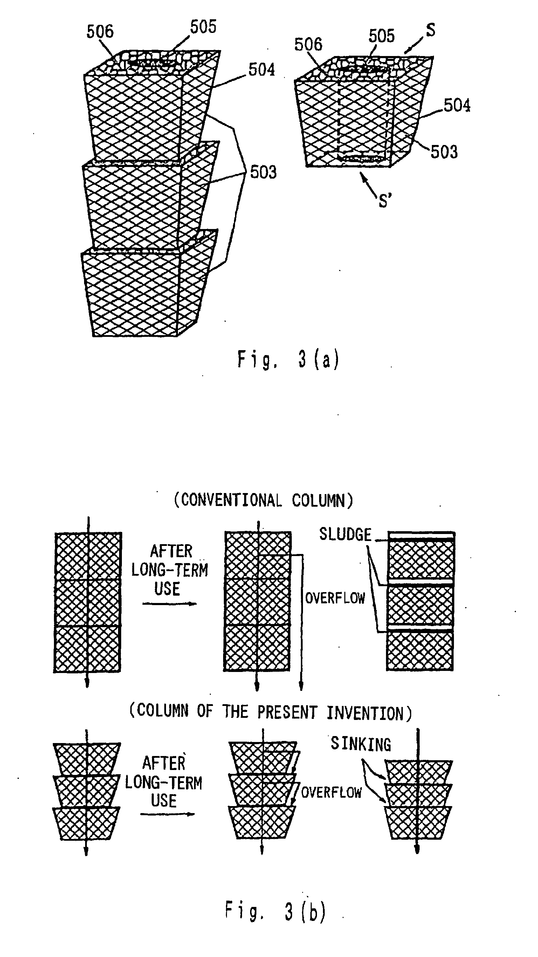

As shown in Fig. 1 and Fig. 3(a), the waste water treating device 500 comprises a plurality of columns 503 which are packed with microorganism carriers and are stacked in contact with one another in a multi-level arrangement within a frame 900. It is also possible to arrange these multi-level columns 503 in a plurality of rows within the frame 900 in accordance with amount of organic waste water to be treated. In Example 1, in the frame 900, three-level columns which are vertically stacked are provided in three rows.

The column 503 comprises a perforated container 504 containing microorganism carriers therein. The column 503 is designed such that the surface area S' at the waste water discharging side is smaller than the surface area S at the waste water introducing side. Preferably, the area S' at the waste water discharging side is less than, but at least half of, the area S at the waste water introducing side.

The container 504 may be a mesh basket, perforated container, or the like. In Example 1, the container 504 of the waste water treating device is a mesh basket whose mesh size (a gap) is 2 ∼ 10 mm, preferably 3 - 7 mm, and more preferably 5 mm. The mesh basket is formed in a truncated pyramid shape having a surface of 13 x 13 square cm at the waste water discharging side and a surface of 15 x 15 square cm at the waste water introducing side. However, the size of the mesh basket is not limited to the above values, but is determined depending on the amount of organic waste water to be treated. Also, the container 504 may be a perforated unglazed container having a great number of small holes.

The upper portion of the container 504 is opened, so that, when a plurality of columns 503 are stacked in multi-levels, the bottom part of the column at the upper level is disposed directly disposed on the microorganism carriers contained in the column at the lower level. With this structure, when the microorganism carries shrink after long term use, the column at the upper level sinks into the column at the lower level.

The microorganism carries contained in the container 504 are wood chips of approximately 2 ∼ 10 mm composed of shaving of Japanese cedar. The organic components contained in the organic waste water are subjected to an oxidization decomposing treatment (aerobic treatment) using the aerobic microorganisms carried on these wood chips. Two types of microorganisms having different average grain size are prepared, and the microorganisms 505 with a smaller average grain size are provided in the center part of the container while the microorganisms 506 with a larger average gain size are concentrically provided outside the microorganisms 505. In Example 1, the microorganisms with a smaller grain size are provided in the center area of the container having a diameter of 5 cm. The ratio of the average grain size of these two types of microorganisms is 1 : 1.5 ∼2.5.

The operation of the waste water treating device 500 of Example 1 having the above-mentioned structure will be described. The organic waste water introduced into the waste water treating device 500 from the waste water introducing side (upper portion) contacts the microorganism carriers, which subject the organic matters in the waste water to an aerobic treatment, and purified water is discharged into sewerage.

The feature of the column 503 of the waste water treating device lies in a whole shape thereof in which the surface area S' at the waste water discharging side is smaller than the surface area S of the waste water introducing side. With the above structure, the column 503 achieves the notable effect in contrast with columns which are conventionally used, as will be described below. Fig. 3(b) is an explanatory view which compares the effects between the conventional waste water treating device (the conventional columns in the figure) and the waste water treating device of the present invention (the columns of the present invention in the figure). The conventional waste water treating device comprises a multi-level stack of columns having the same size surfaces at the waste water discharging and introducing sides.

After the long term use of the waste water treating device, the mesh baskets are clogged with sludge or the like, and the organic waste water to be treated overflows outside the baskets, thereby preventing the aerobic treatment or otherwise lowering the treating efficiency. Further, when the wood chips shrink over long term use, the column at each level develops a gap at the upper portion. If the layers of the microorganism carriers along which the organic waste water flows become discontinuous in this manner, the waste water does not flow smoothly and the sludge in the organic waste water accumulates in this gap, which makes the aerobic treatment inoperative or otherwise decreases the treating efficiency significantly.

To the contrary, in the waste water treating device of Example 1, because the surface area at the waste water discharging side is smaller than the surface area at the waste water introducing side, even when waste water overflows due to accumulation of sludge or the like, the overflowing organic waste water can be introduced into the column at the lower level, where the aerobic treatment is performed as shown in the lower middle figure in Fig. 3(b). Further, when the microorganism carriers shrink after long term use, the column at the upper level naturally sinks into the column at the lower level from the upper side thereof, as shown in the lower right figure of Fig 3(b). Accordingly, and unlike in the conventional columns, no gap is generated, and sludge does not be accumulated in the gap. Smooth flow of the organic waste water can thereby be ensured, in turn ensuring that the efficiency of aerobic treatment is not decreased.

In Example 1, two types of microorganisms carriers having different average grain size are provided. Specifically, the microorganisms carriers 505 with a smaller average grain size are provided in the center area of the container 504 and the microorganisms carriers 506 with a larger average gain size are concentrically provided outside the microorganisms carriers 505. With this structure, a greater amount of the organic waste water tends to flow preferentially along the microorganism carriers 505 having a smaller average grain size provided at the center area, which can bring the organic waste water in close contact with the microorganism carriers so as to achieve the aerobic treatment.

When the microorganism carriers 505 having a smaller grain size provided at the center become clogged after long term use, the organic waste water flows along the microorganism carriers 506 having a larger average grain size provided outer side, whereby aerobic treatment is performed. Thus, a preferable aerobic treatment can be maintained for a relatively long period in comparison with a device using microorganisms carriers of a single grain size.

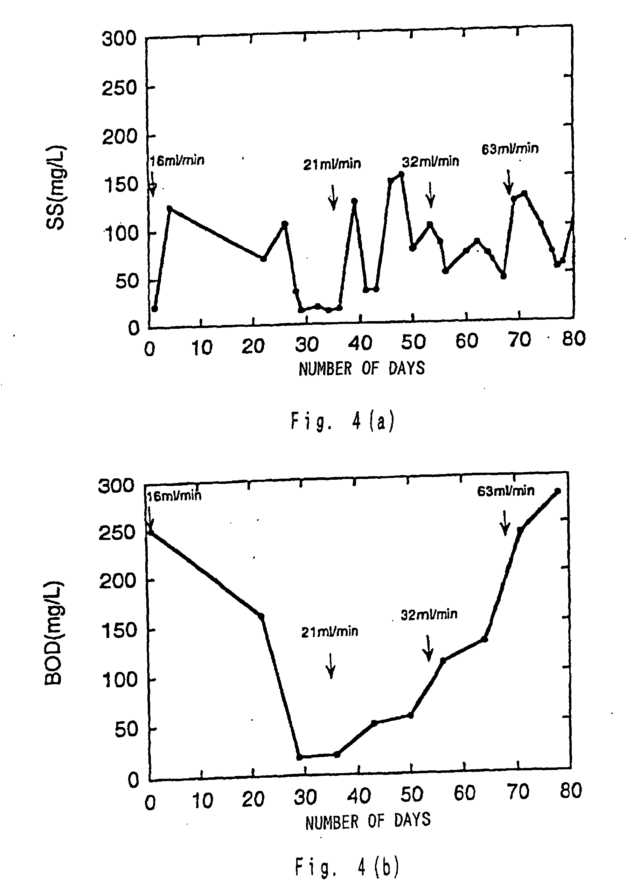

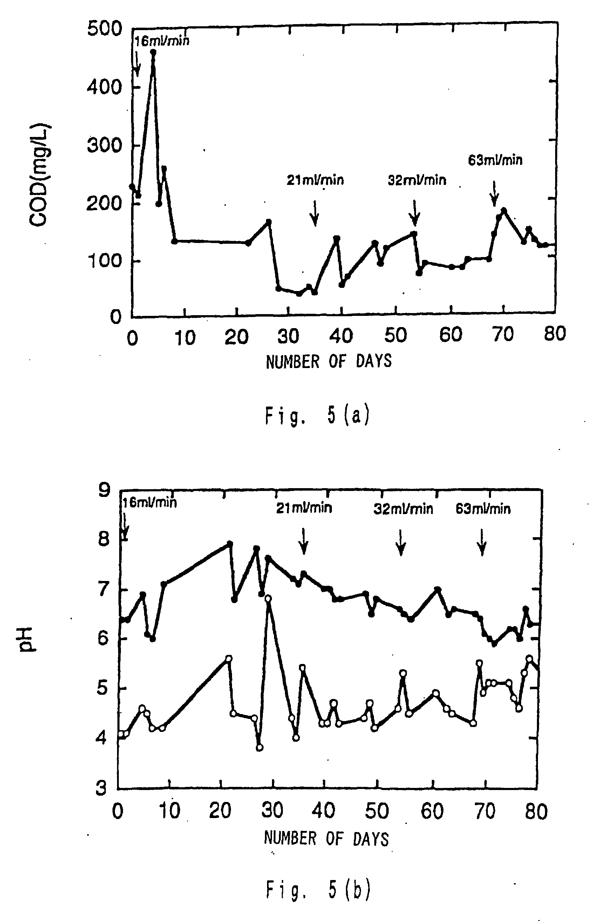

Figs. 4 and 5 are measurement results showing values indicating the quality of water treated by the waste water treating device of Example 1 when a flow rate of water flowing through the device is appropriately changed. (In Figs. 4 and 5, the flow rate at a point indicated by an arrow is maintained until the point indicated by the next arrow.)

The flow rate was appropriately changed for the following reasons. Specifically, it is considered that the treatment performance of the waste water treating device decreases as the flow rate increases, whereas the treatment performance of the device increases as the flow rate decreases. Therefore, by changing the flow rate of the water, it is determined whether or not the measured quality level has any problems in accordance with the environmental standard, what degree the quality level affects the treatment performance, or the like. This consideration is necessary for reviewing the optimal flow rate to be treated in view of the treating flow rate and the treating efficiency. Also, during actual use of this waste water treating device, the flow rate changes each day, and the device must correspond to such a change in the flow rate. Accordingly, the above consideration is also required for reviewing the possibilities of such correspondence or the like.

Figs. 4(a) and 4(b) show results of experiments in which SS and BOD of the treated discharged water was measured respectively, for 80 days with the flow rate of water flowing in the treating device being appropriately changed. The target environmental standard of the discharged water is 300 mg/L or less for both SS and BOD. According to the experimental results, for both SS and BOD, the measurement values did not exceed this standard throughout 80 days even when the flow rate was appropriately changed.

Fig. 5(a) and 5(b) similarly show results of experiments in which COD and pH of the treated discharged water was measured respectively, for 80 days with the flow rate of water flowing in the treating device being appropriately changed. In Fig. 5(a), although somewhat high COD values were measured at the start of the experiment, lower values were obtained as a whole period for the experiment.

In Fig. 5(b), the line at the bottom indicates the measured pH values of the organic waste water introduced in the treating device, and the line at the top indicates the measured pH values of the treated water discharged from the treating device. The organic waste water being introduced into the waste water treating device contains proteins. These proteins were decomposed in the treating device and dissolved, as ammonia, in the discharged water, which increased the pH values of the discharged water. The water was purified until it became neutral or approximately neutral (achieved a pH value of 7 or more).

### (Example 2)

Another example of the present invention will be described. Specifically, a method of recycling the waste water treatment material according to the present invention will be described as Example 2.

The main feature of the method of recycling the waste water treatment material of the waste water treating device in Example 2 is that the microorganism carriers (waste water treatment materials) which have been used in the waste water treating device 500 are recycled in the composting device 600 as microorganism carriers used for aerobically treating the solid substances.

The microorganism carriers used in the waste water treating device, namely the wood chips provided in the columns 503 of the waste water treating device 500 must be changed for approximately every six months because they are clogged after a long term use. At this time, a great amount of used wood chips are produced, however these wood chips, because of the wood fiber remaining therein, must be wasted.

According to Example 2, notice must be made of the fact that the composting device 600 also uses wood chips as microorganism carriers, and that these used wood chips can be used as compost. Then, the wood chips having been used in the waste water treating device 500 are recycled as the microorganism carriers for use in the composting device 600.

Generally, when new wood chips are supplied to the composting device 600, a certain amount of time is required for microorganisms to sufficiently grow so that an aerobic treatment can be performed in a normal condition. According to Example 2, because the wood chips having been used in the waste water treating device 500 contain microorganisms which have sufficiently grown, the time required for preparing the wood chips after they are supplied in the composting device 600 can be reduced, thereby increasing the treating efficiency at the time of changing the microorganism carriers. In addition, the amount of new wood chips to be used in the composting device 600 can be reduced.

After several months, the used wood chips introduced into the composting device 600 are composted and can be used as compost. This recycling method enables effective use of a large amount of waste discharged from the waste water treating device.

In the above example, the microorganism carriers having been used in the waste water treating device which has the structure described in Example 1 are used in the composting device 600. However, it should be understood that the method of recycling the waste water treatment material of Example 2 is also applicable to the microorganism carriers which have been used in the conventional waste water treating device comprising a column having surfaces of the same area size at the waste water introducing side and the waste water discharging side.

While the preferred embodiment of the present invention has been described using specific examples, the present invention is not limited to these examples, and it is to be understood that changes and variations may be made without departing from the spirit or scope of the appended claims.

### Industrial Applicability

The present invention is applicable to an apparatus which treats kitchen waste water containing garbage which has been finely ground by a disposal.

## Claims

1. A waste water treating device for aerobically treating organic waste water using microorganisms held on carriers, said waste water treating device comprising a plurality of columns are packed with microorganism carriers and stacked in multi-levels, wherein
said organic waste water is introduced into the columns, is subjected to an aerobic treatment in the columns, and is then discharged from said waste water treating device, and
in said columns, the area of a surface at the waste water discharging side is smaller than the area of a surface at the waste water introducing side.

2. A waste water treating device according to claim 1, wherein
the area of the surface at the waste water discharging side of the columns is less than, but at least half of, the area of the surface at the waste water introducing side.

3. A waste water treating device according to claim 1 or 2, wherein
said plurality of columns stacked in multi-levels are formed such that a column at the upper level can sink into a column at the lower level.

4. A waste water treating device according to any one of claims 1 to 3, wherein said microorganism carriers are contained in a perforated container.

5. A waste water treating device according to any one of claims 1 to 4, wherein said container and the microorganism carriers are held in contact with each other.

6. A waste water treating device according to any of claims 1 to 5, wherein the microorganism carriers having different average grain size are concentrically provided in said container.

7. A waste water treating device according to any of claims 1 to 6, wherein the ratio of diameters of said microorganism carriers having different average grain size is 1 : 1.5 ∼ 2.5.

8. A waste water treating device according to any of claims 1 to 7, wherein said microorganism carriers are wood chips.

9. A waste water treating device according to any of claims 1 to 8, wherein said container is a mesh basket.

10. A waste water treating device according to claim 9, wherein the mesh size (air gap) of said mesh basket is 3 mm ∼ 7 mm.

11. A waste treatment apparatus according to any of claims 1 to 8, wherein said container is an unglazed container.

12. A method of recycling microorganism carriers used in a waste water treating device, comprising the steps of:
separating waste water containing organic solid substances by a solid-liquid separating device into organic solid substances and organic waste water;
subjecting said solid substances to an aerobic treatment in a composting device, using microorganisms carried on microorganism carriers, for obtaining compost;
aerobically purifying said organic waste water in the waste water treating device, using microorganisms carried on microorganism carriers, and discharging the purified water; and
utilizing the microorganism carriers having been used in said waste water treating device, which are discharged at the time of changing the microorganism carriers, as the microorganism carriers for use in said composting device.
